# EUROPEAN PATENT APPLICATION

(11) **EP 1 584 704 A1**
(43) Date of publication of application: **12.10.2005**
(21) Application number: 05251973.3
(22) Date of filing: 30.03.2005
(51) Int. Cl.: C23C 14/16, C23C 14/32, C23C 14/34, C22C 21/00

(54) **Method for protecting articles, and related compositions**

(30) Priority: 30.03.2004 US 814693
(71) Applicant: GENERAL ELECTRIC COMPANY, Schenectady, NY 12345 (US)
(72) Inventor: Lipkin, Don Mark, Niskayuna New York 12309 (US); Zhao, Ji-Cheng, Latham New York 12110 (US)
(74) Representative: Goode, Ian Roy

(57) **Abstract**

A method for protecting an article from a high temperature, oxidative environment is presented, along with alloy compositions and ion plasma deposition targets (108) suitable for use in the method, and an article for use in such an environment. the method comprises providing a substrate (110), providing an ion plasma deposition target (108), and depositing a protective coating onto the substrate (110) using the target (108) in an ion plasma deposition process. the target (108) comprises from about 2 atom percent to about 25 atom percent chromium, and the balance comprises aluminum.

## Description

This invention relates to oxidation resistant coatings. More particularly, this invention relates to methods of protecting articles from high temperature, oxidative environments using ion plasma deposited coatings. This invention also relates to material compositions suitable for use in the ion deposition process.

Nickel (Ni), cobalt (Co), and iron (Fe) based alloys are frequently used to form articles designed for use in high temperature, highly oxidative environments. Such articles include components that are used in turbine systems, such as, but not limited to, aircraft turbines, land-based turbines, marine-based turbines, and the like. To survive in such environments, articles made of these alloys often require coatings, herein referred to as "high-temperature coatings," to protect the underlying alloys against oxidation and hot corrosion. In some cases, the high-temperature coatings may also serve as bond coating to retain a thermal barrier coating. The high-temperature coating is often a nickel aluminide (NiAl)-based material, sometimes modified by additions of platinum (Pt) to form a platinum nickel aluminide-based coating. In other cases, the high-temperature coating is an alloy comprising chromium (Cr), aluminum (Al), and at least one of iron (Fe), nickel (Ni), and cobalt (Co); these coatings are often referred to in the art as "MCrAlX coatings," where M represents a material comprising at least one of Fe, Ni, and Co, and X represents additional reactive elements as described below.

Addition of reactive elements such as zirconium, hafnium, silicon, titanium, lanthanum, cerium, yttrium, and the like, have been found to be effective in improving the performance of nickel aluminide-based and MCrAlX-based coatings. However, adding the reactive elements to the coatings in a manner that is cost-effective and consistent has proven to be a significant technical challenge. For example, although electron beam physical vapor deposition (EBPVD) has been used to deposit NiAl-based and MCrAIX-based coatings, maintaining compositional control of the reactive elements has proven to be difficult, leading to unacceptable variability in coating performance. Chemical vapor deposition (CVD) techniques also suffer from problems with compositional inconsistency, which increase as the compositional complexity of the desired coating alloy increases.

The ion plasma deposition (IPD) process provides an attractive alternative to CVD and EB-PVD for high-temperature coating deposition, offering advantages in both compositional control and lower production equipment cost over the former. However, the NiAl-based target materials from which the deposit is made are very brittle, limiting the application of IPD in production environments.

Therefore, there is a need to provide high temperature coatings with improved performance, consistency, and cost-effectiveness. There is also a need for materials suitable for use as targets in the IPD coating process that provide more reliable, cost-effective performance.

Embodiments of the present invention are provided to address these and other needs. One embodiment is a method for protecting an article from a high temperature, oxidative environment. The method comprises providing a substrate, providing an ion plasma deposition target, and depositing a protective coating onto the substrate using the target in an ion plasma deposition process. The target comprises from about 2 atom percent to about 25 atom percent chromium, and the balance comprises aluminum.

A second embodiment is an alloy comprising:
from about 2 atom percent to about 25 atom percent chromium,
up to about 4 atom percent of a material selected from the group consisting of zirconium, hafnium, tantalum, silicon, yttrium, titanium, lanthanum, cerium, and combinations thereof;
up to about 0.2 percent of a material selected from the group consisting of carbon, boron, and combinations thereof; and
the balance comprising aluminum.

A third embodiment is a target for use in an ion plasma deposition process, comprising the alloy of the present invention.

A fourth embodiment is an article for use in a high temperature, oxidative environment. The article comprises a substrate and a coating disposed on the substrate, and the coating comprises the article of the present invention.

These and other features, aspects, and advantages of the present invention will become better understood when the following detailed description is read with reference to the accompanying drawings in which like characters represent like parts throughout the drawings, wherein:

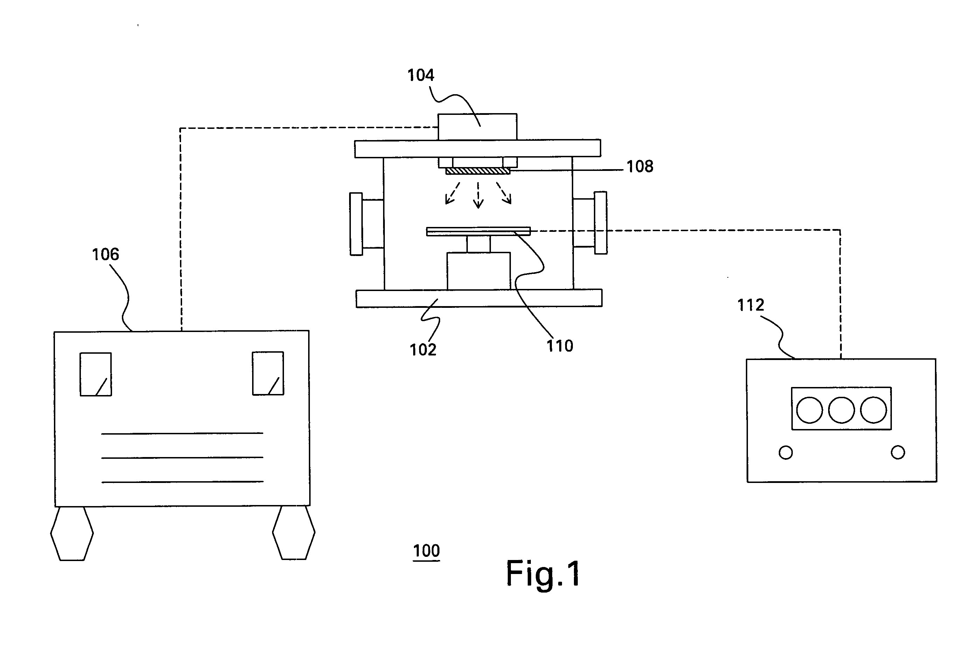

Figure 1 is a schematic of an ion plasma deposition apparatus.

Ion Plasma Deposition (IPD) is a physical vapor deposition process that has been used in such industrial applications as wear-resistant coatings, decorative coatings, and high-temperature protective coatings. Referring to Figure 1, an exemplary IPD coating apparatus 100 in part comprises a vacuum chamber 102 upon which is mounted a cathodic arc source 104. Cathodic arc source 104 is coupled to a first DC power supply 106 and in part comprises a target 108, which is made of the material to be deposited. During the IPD process, an electric arc sweeping across the cathodic arc source 104 evaporates material at the surface of the target 108, and the evaporated material is then deposited on the substrate 110. In an arc discharge, the cathodic current is concentrated at minute, extremely energetic cathode arc spots, producing an electron current in a plasma of highly ionized metal vapor. Because of the high energy of the arc process, all alloying elements of a target material are uniformly ejected, promoting consistent and predictable compositional transfer of material from target 108 to substrate 110. The process is carried out in a typical vacuum of 10⁻³ to 10⁻⁶ Torr. No crucible material is needed to contain molten material, in contrast to other PVD methods. Consequently, IPD advantageously produces dense, multicomponent coatings of high purity.

Embodiments of the present invention include a method for protecting an article from a high temperature, oxidative environment, using a coating process based on the IPD method. In these embodiments, a substrate 110 is provided. The term "substrate" as used herein means any article upon which a coating is subsequently disposed. Substrate 110 comprises at least one of a nickel alloy, an iron alloy, and a cobalt alloy in some embodiments, including, for example, the class of high strength, high temperature alloys well-known in the art as "superalloys." In particular embodiments, providing a superalloy substrate comprises providing a component for service in a hot gas path of a gas turbine assembly. Examples of such components include, but are not limited to, turbine blades, vanes, and combustion components such as liners and transition pieces. The method of the present invention is suitable for use as a method for protecting a new article and as a method for protecting an article that has been previously used. For example, the method of the present invention is suitable for use in a repair process for articles that have been used previously in a high temperature, oxidative environment, such as a gas turbine assembly. Accordingly, in certain embodiments of the present invention, the provided substrate 110 comprises at least one coating. Depending on the composition and condition of the coating on substrate 110, the coating may be removed prior to being provided for the method of the present invention, or the substrate may be provided with the coating attached.

An IPD target 108 is provided. Target 108 comprises from about 2 atom percent to about 25 atom percent chromium, and the balance comprises aluminum. Using such an alloy composition for target 108 provides several advantages over other methods for manufacturing NiAl-based coatings. The material used for target 108 in embodiments of the present invention is significantly less expensive and more easily machined than the commonly used NiAl-based materials. Furthermore, the excellent compositional transfer characteristics of the IPD method used in the present invention allow the well-controlled incorporation of reactive elements into the coating process. Accordingly, in some embodiments the provided target 108 further comprises at least one of zirconium, hafnium, tantalum, silicon, yttrium, titanium, lanthanum, cerium, carbon, and boron. In certain embodiments, target 108 further comprises up to about 4 atom percent of a material selected from the group consisting of zirconium, hafnium, tantalum, silicon, yttrium, titanium, lanthanum, cerium, and combinations thereof; and up to about 0.2 percent of a material selected from the group consisting of carbon, boron, and combinations thereof. In particular embodiments, target 108 comprises about 9 atom percent chromium, about 1 atom percent zirconium, and the balance comprises aluminum. In alternative embodiments, target 108 comprises about 9 atom percent chromium, about 1 atom percent zirconium, about 2 atom percent tantalum, and the balance comprises aluminum. In further alternative embodiments, target 108 comprises about 9 atom percent chromium, about 1.5 atom percent hafnium, about 1.5 atom percent silicon, and the balance comprises aluminum. Those skilled in the art will recognize that a particular choice of alloy composition for target 108 depends upon several factors, including the choice of substrate 110 material and the type of environmental exposure expected to be endured by the protected article.

In a typical commercially available IPD coating apparatus, target 108 is in the form of a simple shape, such as, but not limited to, a cylinder. The materials described above as suitable target 108 materials are manufactured by materials processing methods common in the art. Those skilled in the art will understand that commonly used metallurgical and manufacturing processes are suitable for the manufacture of the alloys, and in the formation of the alloys into IPD targets for use in embodiments of the present invention. Accordingly, in some embodiments, providing the ion plasma deposition target 108 comprises providing a target 108 manufactured using at least one of casting and powder metallurgy processing.

A protective coating is deposited onto substrate 110 using target 108 in an IPD process as described above. In some embodiments, a negative potential bias is applied to substrate 110, for example by a second DC power supply 112 coupled to substrate 110. Applying the negative potential bias results in an increase in substrate heating during IPD coating, and this heating causes interdiffusion and reaction among the elements of the deposited material and the material of substrate 110 to form, in situ, advantageous coating compositions. For example, in embodiments in which substrate 110 comprises a nickel-based superalloy, biasing the substrate 110 during IPD coating of the aluminum-rich alloy from the target 108 causes an interaction to occur between the two materials, transforming the protective coating from an aluminum alloy coating (of composition similar to, or identical with, the composition of target 108) to one comprising NiAl-based material. In certain embodiments, applying the negative potential bias comprises applying a potential bias in the range from about -10 volts to about -1000 volts, for example, a potential bias in the range from about -50 volts to about -250 volts. The particular value chosen for the potential bias depends on, for instance, the amount and type of interaction desired to occur between the deposited material and the substrate 110 material. In alternative embodiments, depositing the protective coating onto the substrate further comprises grounding the substrate, which heats the substrate in a similar manner to applying a bias and causes an interaction as described above.

The thickness of the protective coating is generally determined by factors such as, for example, the time and temperature of exposure expected for the substrate 110 being protected. In some embodiments, the protective coating is deposited to have a thickness in the range of from about 5 micrometers to about 250 micrometers. In particular embodiments, the coating thickness is in the range from about 25 micrometers to about 75 micrometers. Moreover, a protective coating made by the method of the present invention is suitable for use as a bondcoat in a thermal barrier coating system. Accordingly, in certain embodiments of the present invention, the method further comprises coating said protective layer with a thermal barrier coating such as, for example, a thermal barrier coating comprising yttria-stabilized zirconia. Application of the thermal barrier coating is accomplished via any of several suitable processes, including, but not limited to, plasma spraying and physical vapor deposition.

Embodiments of the present invention include variations on the method described above. In some embodiments, the method of the present invention further comprises coating substrate 110 with a metal layer prior to depositing the protective coating.

Any of several coating methods is suitable to coat substrate 110 with this metal layer, including, but not limited to, electroplating, electroless plating, chemical vapor deposition, and physical vapor deposition. The metal layer is deposited at a thickness in the range from about 2 micrometers to about 25 micrometers in some embodiments, and in particular embodiments, the thickness of the metal layer is in the range from about 2 micrometers to about 6 micrometers. In certain embodiments, the metal layer comprises at least one of platinum, palladium, nickel, and cobalt. The use of nickel or cobalt in the metal layer makes these materials available for subsequent reaction with the protective coating to form desirable high-temperature phases such as nickel aluminide. Coating substrate 110 with a metal layer comprising at least one of platinum and palladium prior to depositing the protective coating gives the method the potential to form, for example, platinum modified nickel aluminide-based protective coatings. In certain embodiments, substrate 110 is heat treated after coating substrate 110 with the metal layer, for example at a temperature in the range from about 700°C to about 1200°C for a time in the range from about 30 minutes to about 8 hours. This heat treatment step allows interdiffusion of the metal layer material and the substrate material, such as, for instance, creating a Pt-enriched Ni-bearing layer at the surface of substrate 110.

Subsequent deposition of the Al-rich alloy in accordance with the method of the present invention, along with interaction of the Al-rich material with, for example, the Pt-enriched Ni-bearing substrate 110 as described in the example above, can create a platinum modified nickel aluminide-based protective coating. The interaction can be created in situ during the IPD coating step by applying a bias to, or by grounding, substrate 110 as described previously. Furthermore, the method of the present invention, in some embodiments, further comprises heat treatment of the substrate after depositing the protective coating. The heat treatment times and temperatures described above for heat treating the metal layer are suitable for heat treating the protective coating as well. This heat treatment may be used in conjunction with biasing or grounding substrate 110 to further augment the interaction between coating and substrate materials, or the heat treatment of the substrate after depositing the protective coating may be used to cause the entirety of the interaction, in embodiments where a substantial interaction is not generated during IPD coating.

The use of heat treatment, substrate bias, substrate grounding, and combinations thereof, as described above, is generally directed towards the creation of a protective coating on the surface of substrate 110 by causing elements from the substrate to interact with the aluminum-rich alloy deposited during the IPD process to form various protective materials. The example of coating a Ni-based substrate to form an alloyed NiAl-based protective coating has been described above. Advantageously, the method of the present invention allows the formation of such a coating without the need for a NiAl-based target 108, which would be significantly more complex to manufacture and more brittle than the target 108 according to embodiments of the present invention.

Those skilled in the art will appreciate that, through selection of the composition of substrate 110, target 108, heat treatment, and, in some embodiments, the metal layer, the method of the present invention may be used to control the composition of the protective coating. In some embodiments, depositing the protective coating comprises forming a protective coating comprising at least 80 volume percent of a single phase, such as, for example, a B2-structured aluminide intermetallic phase commonly observed in NiAl-based high temperature coatings. In other embodiments, depositing said protective coating comprises forming a protective coating comprising at least two phases, such as, for example, the aforementioned B2-structured phase and a platinum aluminide, PtAl₂, which is commonly observed in platinum modified nickel aluminide-based high temperature coatings. Thus, the method of the present invention may be used in certain embodiments to create coatings with structures, compositions, and properties commonly used in industry as protective, high temperature coatings.

In order to take further advantage of the benefits of embodiments described above, a further embodiment of the present invention is a method for protecting an article from a high temperature, oxidative environment, the method comprising:
providing a substrate 110 comprising a nickel-based superalloy;
providing an ion plasma deposition target 108, the target 108 comprising
   from about 2 atom percent to about 25 atom percent chromium,
   up to about 4 atom percent of a material selected from the group consisting of zirconium, hafnium, tantalum, silicon, yttrium, titanium, lanthanum, cerium, and combinations thereof,
   up to about 0.2 percent of a material selected from the group consisting of carbon, boron, and combinations thereof, and
   the balance comprising aluminum;
depositing a protective coating onto the substrate 110 using the target 108 in an ion plasma deposition process, wherein a negative potential bias is applied to the substrate 110 during deposition of the protective coating; and
heat treating the substrate 110 after depositing the protective coating;
wherein after heat treating, the protective coating comprises a B2-structured aluminide intermetallic phase. The additional steps of coating substrate 110 with a metal layer comprising at least one of platinum, palladium, nickel, and cobalt, and heat treating substrate 110 after coating substrate 110 with the metal layer, described previously, are applicable to this embodiment as well.

As described above, the method of the present invention advantageously allows the use of relatively inexpensive, easily machined aluminum-rich alloys to form, for example, aluminide-based protective coatings. Accordingly, embodiments of the present invention further include an alloy suitable for use in the method of the present invention. This alloy has been described above in the discussion pertaining to the step of providing an IPD target 108, along with multiple examples of particular alloys within the described composition range. Embodiments of the present invention also include a target for use in an ion plasma deposition process, comprising the alloy of the present invention as described above; and further embodiments include an article for use in a high temperature, oxidative environment, wherein the article comprises a substrate and a coating disposed on the substrate, and the coating comprises the alloy of the present invention as described above.

For completeness, various aspects of the invention are set out in the following numbered clauses:-
1. A method for protecting an article from a high temperature, oxidative environment, said method comprising:
   providing a substrate (110);
   providing an ion plasma deposition target (108), said target (108) comprising
      from about 2 atom percent to about 25 atom percent chromium, and
      at least about 70 atom percent aluminum; and
   depositing a protective coating onto said substrate (110) using said target (108) in an ion plasma deposition process.
2. The method of clause 1, wherein providing said target (108) comprises providing a target (108) further comprising at least one of zirconium, hafnium, tantalum, silicon, yttrium, titanium, lanthanum, cerium, carbon, and boron.
3. The method of clause 2, wherein providing said target (108) comprises providing a target (108) further comprising up to about 4 atom percent of a material selected from the group consisting of zirconium, hafnium, tantalum, silicon, yttrium, titanium, lanthanum, cerium, and combinations thereof; and up to about 0.2 percent of a material selected from the group consisting of carbon, boron, and combinations thereof.
4. The method of clause 1, further comprising:
   coating said substrate (110) with a metal layer prior to depositing said protective coating.
5. The method of clause 4, wherein coating said substrate (110) with a metal layer comprises coating said substrate (110) with a metal layer comprising at least one of platinum, palladium, nickel, and cobalt.
6. The method of clause 1, further comprising heat treating said substrate (110) after depositing said protective coating.
7. The method of clause 1, wherein providing said substrate (110) comprises providing at least one of a nickel alloy, an iron alloy, and a cobalt alloy.
8. The method of clause 1, wherein depositing said protective coating onto said substrate (110) further comprises applying a negative potential bias to said substrate (110).
9. The method of clause 1, wherein depositing said protective coating onto said substrate (110) further comprises grounding said substrate (110).
10. The method of clause 1, wherein depositing said protective coating comprises forming a protective coating comprising at least 80 volume percent of a single phase.
11. The method of clause 10, wherein depositing said protective coating comprises forming a protective coating comprising at least 80 volume percent of a B2-structured aluminide intermetallic phase.
12. The method of clause 1, wherein depositing said protective coating comprises forming a protective coating comprising at least two phases.
13. The method of clause 12, wherein depositing said protective coating comprises forming a protective coating comprising a B2-structured aluminide intermetallic phase and platinum aluminide (PtAl₂).
14. A method for protecting an article from a high temperature, oxidative environment, said method comprising:
   providing a substrate (110) comprising a nickel-based superalloy;
   providing an ion plasma deposition target (108), said target (108) comprising
      from about 2 atom percent to about 25 atom percent chromium,
      up to about 4 atom percent of a material selected from the group consisting of zirconium, hafnium, tantalum, silicon, yttrium, titanium, lanthanum, cerium, and combinations thereof,
      up to about 0.2 percent of a material selected from the group consisting of carbon, boron, and combinations thereof, and
      at least about 70 atom percent aluminum;
   depositing a protective coating onto said substrate (110) using said target (108) in an ion plasma deposition process, wherein a negative potential bias is applied to said substrate (110) during deposition of said protective coating; and
   heat treating said substrate (110) after depositing said protective coating;
   wherein after heat treating, said protective coating comprises a B2-structured aluminide intermetallic phase.
15. An alloy comprising:
   from about 2 atom percent to about 25 atom percent chromium; up to about 4 atom percent of a material selected from the group consisting of zirconium, hafnium, tantalum, silicon, yttrium, titanium, lanthanum, cerium, and combinations thereof;
   up to about 0.2 percent of a material selected from the group consisting of carbon, boron, and combinations thereof; and
   at least about 70 atom percent aluminum.
16. The alloy of clause 15, wherein said alloy comprises at least about 80 atom percent aluminum.
17. The alloy of clause 16, wherein said alloy comprises at least about 85 atom percent aluminum.
18. The alloy of clause 15, wherein said alloy comprises:
   about 9 atom percent chromium;
   about 1 atom percent zirconium; and
   at least about 85 atom percent aluminum..
19. The alloy of clause 15, wherein said alloy comprises:
   about 9 atom percent chromium;
   about 1 atom percent zirconium;
   about 2 atom percent tantalum; and
   at least about 85 atom percent aluminum..
20. The alloy of clause 15, wherein said alloy comprises:
   about 9 atom percent chromium;
   about 1.5 atom percent hafnium;
   about 1.5 atom percent silicon; and
   at least about 85 atom percent aluminum..
21. A target (108) for use in an ion plasma deposition process, said target (108) comprising:
   an alloy comprising
      from about 2 atom percent to about 25 atom percent chromium, up to about 4 atom percent of a material selected from the group consisting of zirconium, hafnium, tantalum, silicon, yttrium, titanium, lanthanum, cerium, and combinations thereof,
      up to about 0.2 percent of a material selected from the group consisting of carbon, boron, and combinations thereof, and
      at least about 70 atom percent aluminum.

## Claims

1. A method for protecting an article from a high temperature, oxidative environment, said method comprising:
providing a substrate (110);
providing an ion plasma deposition target (108), said target (108) comprising
from about 2 atom percent to about 25 atom percent chromium, and
at least about 70 atom percent aluminum; and
depositing a protective coating onto said substrate (110) using said target (108) in an ion plasma deposition process.

2. The method of claim 1, wherein providing said target (108) comprises providing a target (108) further comprising at least one of zirconium, hafnium, tantalum, silicon, yttrium, titanium, lanthanum, cerium, carbon, and boron.

3. The method of claim 2, wherein providing said target (108) comprises providing a target (108) further comprising up to about 4 atom percent of a material selected from the group consisting of zirconium, hafnium, tantalum, silicon, yttrium, titanium, lanthanum, cerium, and combinations thereof; and up to about 0.2 percent of a material selected from the group consisting of carbon, boron, and combinations thereof.

4. The method of claim 1, further comprising:
coating said substrate (110) with a metal layer prior to depositing said protective coating.

5. The method of claim 1, further comprising heat treating said substrate (110) after depositing said protective coating.

6. The method of claim 1, wherein providing said substrate (110) comprises providing at least one of a nickel alloy, an iron alloy, and a cobalt alloy.

7. The method of claim 1, wherein depositing said protective coating comprises forming a protective coating comprising at least 80 volume percent of a single phase.

8. A method for protecting an article from a high temperature, oxidative environment, said method comprising:
providing a substrate (110) comprising a nickel-based superalloy;
providing an ion plasma deposition target (108), said target (108) comprising
from about 2 atom percent to about 25 atom percent chromium,
up to about 4 atom percent of a material selected from the group consisting of zirconium, hafnium, tantalum, silicon, yttrium, titanium, lanthanum, cerium, and combinations thereof,
up to about 0.2 percent of a material selected from the group consisting of carbon, boron, and combinations thereof, and
at least about 70 atom percent aluminum;
depositing a protective coating onto said substrate (110) using said target (108) in an ion plasma deposition process, wherein a negative potential bias is applied to said substrate (110) during deposition of said protective coating; and
heat treating said substrate (110) after depositing said protective coating;
wherein after heat treating, said protective coating comprises a B2-structured aluminide intermetallic phase.

9. An alloy comprising:
from about 2 atom percent to about 25 atom percent chromium; up to about 4 atom percent of a material selected from the group consisting of zirconium, hafnium, tantalum, silicon, yttrium, titanium, lanthanum, cerium, and combinations thereof;
up to about 0.2 percent of a material selected from the group consisting of carbon, boron, and combinations thereof; and
at least about 70 atom percent aluminum.

10. The alloy of claim 9, wherein said alloy comprises at least about 80 atom percent aluminum.
